# EUROPEAN PATENT APPLICATION

(11) **EP 4 750 235 A1**
(43) Date of publication of application: **27.05.2026**
(21) Application number: 24843342.7
(22) Date of filing: 24.06.2024
(51) Int. Cl.: H05K 7/20

(54) **HEAT DISSIPATION APPARATUS FOR ELECTRONIC DEVICE**

(30) Priority: 19.07.2023 KR 20230094007; 21.06.2024 KR 20240081081
(71) Applicant: KMW Inc., Hwaseong-si, Gyeonggi-do 18462 (KR)
(72) Inventor: YOO, Chang Woo, Hwaseong-si Gyeonggi-do 18378 (KR); RYU, Chi Back, Hwaseong-si Gyeonggi-do 18378 (KR); PARK, Hyun Jin, Hwaseong-si Gyeonggi-do 18445 (KR); KANG, Hyo Sik, Hwaseong-si Gyeonggi-do 18374 (KR); CHOI, In Hwa, Yongin-si Gyeonggi-do 17148 (KR)
(74) Representative: impuls legal PartG mbB
(86) International application number: PCT/KR2024/008715
(87) International publication number: WO 2025/018622

(57) **Abstract**

The present invention relates to a heat dissipation apparatus for an electronic device, the heat dissipation apparatus comprising: a heat dissipation housing having an inner space and open at the front; various types of heating elements that are arranged in a plurality of regions in the up-down direction on an inner surface corresponding to the inner space of the heat dissipation housing; and a plurality of heat sink fins that are arranged lengthwise in the up-down vertical direction on the back surface of the heat dissipation housing and detachably coupled so as to be spaced at certain intervals in the left-right horizontal direction. The plurality of heat sink fins are arranged so as to be discontinuous in the up-down direction near the boundaries of the plurality of regions, and thus provide the advantage of significantly improving heat dissipation performance.

## Description

### [Technical Field]

The present disclosure relates to a heat dissipation apparatus for an electronic device, and more particularly, to a heat dissipation apparatus for an electronic device that can enhance heat dissipation performance corresponding to a plurality of heat generating elements having different heat generation amounts and different heat generation positions.

### [Background Art]

In various industrial fields such as communications, electronics, and electricity, related technologies are being continuously developed to a high level for application to more advanced industries. The development of advanced technologies requires high-output energy, and devices using high-output energy inevitably face problems of high heat generation, so that the development of a heat dissipation system at an appropriate level is required.

The heat dissipation system is used in various industries, including air conditioners, mobile communications, data centers, aerial mobility, electric vehicles, energy storage devices, and displays. Such a heat dissipation system is one of the major causes of power consumption, and power consumption tends to increase gradually as industries continue to develop.

In general, a heat dissipation device is mainly classified into an active cooling device and a passive cooling device. The active cooling device mainly utilizes forced convection by means of a fan, whereas the passive cooling device utilizes natural convection without using a fan.

However, a conventional heat dissipation system is limited in its ability to dissipate high heat generated by continuously advancing, high-level technologies. Thus, in related industrial fields, there is a demand for innovative technologies capable of addressing such a problem, and as one approach to solving this problem, a heat dissipation mechanism using a phase-change material has been developed.

Further, an electronic device is provided with various types of heat generating elements that operate electrically but generate different amounts of heat. Depending on the purpose and usage conditions of the electronic device, there may be cases in which multiple types of heat generating elements are inevitably required to dissipate heat through only one surface of the electronic device.

In this case, in order to facilitate heat dissipation from an inner space of the electronic device to the outside (outside air), a heat dissipation housing made of a thermally conductive material and covering the one surface through which heat dissipation is performed is provided, and a plurality of heat sink fins for increasing a heat exchange area with the outside air may be integrally or detachably provided on an outer surface of the heat dissipation housing.

However, when the plurality of heat sink fins are uniformly arranged on the outer surface of the heat dissipation housing with the same specifications and the same spacing, without considering the plurality types of heat generating elements and their respective arrangement positions, and are vertically arranged in an up-and-down direction so as to prevent interference of upward airflow, heat inside the electronic device may be concentrated toward an upper portion due to upward airflow, thereby causing different heat dissipation requirements in the vertical direction and making uniform heat dissipation difficult.

Further, even when each individual heat sink fin forming the plurality of heat sink fins has a large length so as to extend over the entire vertical direction of the outer surface of the heat dissipation housing, heat conducted from a lower portion inside the electronic device may, during a process of being transferred upward, adversely affect the heat generating elements mounted in an upper region, which are vulnerable to high temperatures, thereby leading to degradation in performance of specific heat generating elements.

For example, when a material used as a heat transfer medium is a phase-changeable refrigerant, unlike a case relying on thermal conductivity of a metal material itself, the heat dissipation performance is very high, and thus, high temperature of condensation heat generated when a gaseous refrigerant condenses into a liquid refrigerant may instead lead to functional degradation of the heat generating elements that are vulnerable to heat.

### [Disclosure]

### [Technical Problem]

The present disclosure is proposed to resolve the aforementioned technical problems and is to provide a heat dissipation apparatus for an electronic device that allows internal heat to be dissipated with uniform heat dissipation performance over an entire vertical region by dividing a plurality of heat sink fins provided on a back surface of a heat dissipation housing into specific heat dissipation regions according to vertical positions of the back surface of the heat dissipation housing and mounting the heat sink fins accordingly.

Another object of the present disclosure is to provide a heat dissipation apparatus for an electronic device that can prevent a reverse heat conduction phenomenon inside a heat dissipation housing that may occur when heat dissipation performance of a plurality of heat sink fins is significantly increased.

Still another object of the present disclosure is to provide a heat dissipation apparatus for an electronic device that enables rapid heat dispersion in a left-right horizontal direction from some heat generating elements that generate high levels of heat.

Yet another object of the present disclosure is to provide a heat dissipation apparatus for an electronic device that utilizes not only heat conduction according to inherent materials of a plurality of heat sink fins depending on their installation positions, but also phase change of a refrigerant.

Still yet another object of the present disclosure is to provide a heat dissipation apparatus for an electronic device in which, when a plurality of heat sink fins utilize phase change of a refrigerant, heat dissipation regions in a vertical direction are divided and designed such that functional degradation of heat generating elements due to condensation heat is minimized as much as possible.

Technical issues of the present disclosure are not limited to the technical issues mentioned above, and other technical issues not mentioned above will be clearly understood by those skilled in the art from the following description.

### [Technical Solution]

A heat dissipation apparatus for an electronic device according to an embodiment of the present disclosure includes a heat dissipation housing having an inner space that is open at a front, various types of heat generating elements disposed in a plurality of regions in a vertical direction on an inner surface corresponding to the inner space of the heat dissipation housing, and a plurality of heat sink fins disposed on a back surface of the heat dissipation housing to extend long in an up-down vertical direction and detachably coupled to be spaced apart from each other by a predetermined distance in a left-right horizontal direction, and the plurality of heat sink fins are separately disposed so as to be discontinuous in the vertical direction near boundaries between a plurality of regions.

The plurality of heat sink fins may be separately disposed so as to interrupt conductive heat transfer in the vertical direction with respect to the back surface of the heat dissipation housing.

When the plurality of regions are divided into an upper region relatively positioned on a upper portion of the back surface of the heat dissipation housing, an intermediate region positioned on a middle portion, and a lower region positioned oln a lower portion, the plurality of heat sink fins may be installed on the back surface of the heat dissipation housing so as to independently receive heat from the heat generating elements positioned on the respective regions and then to dissipate the heat through independent heat transfer paths.

When the plurality of regions are divided into an upper region relatively positioned on an upper portion of the back surface of the heat dissipation housing, an intermediate region positioned on a middle portion, and a lower region positioned on a lower portion, the plurality of heat sink fins may include an upper heat sink fin coupled to the upper region to dissipate heat from an upper heat generating element positioned in the upper region among the plurality of types of heat generating elements. an intermediate heat sink fin coupled to the intermediate region to dissipate heat from an intermediate heat generating element positioned in the intermediate region among the plurality of types of heat generating elements, and a lower heat sink fin coupled to the lower region to dissipate heat from a lower heat generating element positioned in the lower region among the plurality of types of heat generating elements.

The upper heat sink fin, the intermediate heat sink fin, and the lower heat sink fin may be arranged on a straight vertical line in the vertical direction.

The upper heat sink fin and the intermediate heat sink fin may have a first thermal conductivity, the lower heat sink fin may have a second thermal conductivity that is relatively lower than the first thermal conductivity, and the upper heat generating element and the intermediate heat generating element positioned in the upper region and the intermediate region may dissipate heat at a higher temperature than the lower heat generating element positioned in the lower region.

A phase-changeable refrigerant may be filled inside the upper heat sink fin and the intermediate heat sink fin, and the first thermal conductivity may be provided through flow of the refrigerant caused by phase change of the refrigerant.

The lower heat sink fin may have the second thermal conductivity by thermal conductivity of a material itself.

The upper heat sink fin may further include an extended heat dissipation plate portion integrally formed thereon, a portion of an upper end thereof extending further forward than the back surface of the heat dissipation housing so as to cover at least a portion of an upper surface of the heat dissipation housing.

The extended heat dissipation plate portion may be formed such that a refrigerant flow space filled with the refrigerant is extended inside the upper heat sink fin.

In the intermediate region, a high heat generating element having a greater amount of heat generation than the intermediate heat generating element may be further positioned in addition to the intermediate heat generating element, and the intermediate region may be divided into an upper intermediate region including a portion in which the high heat generating element is positioned and a lower intermediate region including a portion in which the high heat generating element is not positioned.

A plurality of heat pipes for dispersing heat generated from the high heat generating element in the left-right horizontal direction of the heat dissipation housing may be installed on an inner surface of the inner space of the heat dissipation housing corresponding to the upper intermediate region.

The back surface of the heat dissipation housing may further include press-fitting portions for installation of the plurality of heat sink fins, and when the press-fitting portions include an upper press-fitting portion to which the upper heat sink fin among the plurality of heat sink fins is coupled, an intermediate press-fitting portion to which the intermediate heat sink fin among the plurality of heat sink fins is coupled, and a lower press-fitting portion to which the lower heat sink fin among the plurality of heat sink fins is coupled, a back surface of the heat dissipation housing on which the intermediate press-fitting portion is formed may be configured to be distinguished by a stepped surface.

A front end portion of the intermediate heat sink fin positioned in the upper intermediate region may be formed to be recessed rearward in a stepped manner relative to a front end portion of the intermediate heat sink fin positioned in the lower intermediate region.

The upper heat sink fin and the intermediate heat sink fin each may include a heat-conductive panel body having a refrigerant flow space, which provides a space in which the refrigerant is filled and circulates in a gas-liquid phase within a closed space to release heat through phase change.

The refrigerant flow space may include a first refrigerant path serving as an evaporation region and positioned at one end in a width direction to receive heat from the upper heat generating element and the intermediate heat generating elements to be dissipated through the heat-conductive panel body, and a plurality of second refrigerant paths formed in a condensation region other than the first refrigerant path, the second refrigerant paths serving as flow paths through which a liquid refrigerant, among the refrigerants, condensed from a gaseous state to a liquid state flows from the other end in the width direction of the heat-conductive panel body toward the first refrigerant path by surface tension or gravity.

The heat-conductive panel body of the upper heat sink fin and the intermediate heat sink fin may be provided in the form of a sheet made of a SUS (stainless steel) material, and the lower heat sink fin may be provided in the form of a sheet made of an aluminum material having higher thermal conductivity than the heat-conductive panel body.

The heat-conductive panel body of the upper heat sink fin and the intermediate heat sink fin may be provided in the form of a sheet made of a SUS material forming the refrigerant flow space, and the lower heat sink fin may be provided in the form of a sheet made of a SUS material that does not include the refrigerant flow space.

### [Advantageous Effects]

According to a heat dissipation apparatus for an electronic device of the present disclosure, heat concentration caused by a plurality of types of heat generating elements inside a heat dissipation housing formed to extend vertically is prevented, thereby enabling heat dissipation to be performed with overall uniform heat dissipation performance and significantly improving heat dissipation performance.

In addition, according to a heat dissipation apparatus for an electronic device of the present disclosure, reverse heat conduction that may occur due to high heat dissipation performance of a plurality of heat sink fins is prevented, thereby protecting heat generating elements, which are vulnerable to high temperatures, inside the electronic device and improving product reliability.

### [Description of Drawings]

FIG. 1 is front-portion and rear-portion perspective views illustrating a heat dissipation apparatus for an electronic device according to an embodiment of the present disclosure;
FIGS. 2A and 2B are an exploded perspective view of the front portion and an exploded perspective view of the rear portion of FIG. 1, respectively;
FIG. 3 is a partially exploded rear-portion perspective view for explaining a coupling relationship of a plurality of heat sink fins among components of FIG. 1;
FIG. 4 includes perspective views (a, b, c) illustrating the plurality of heat sink fins among the components of FIG. 1, and cross-sectional views (d, e) taken along lines A-A and B-B, respectively;
FIG. 5 is a projected perspective view illustrating an upper heat sink fin among the plurality of heat sink fins of FIG. 1;
FIG. 6 is an exploded perspective view of FIG. 5;
FIG. 7 includes a partially cut-away perspective view (a) of FIG. 5, an enlarged view (b) of the cut-away portion, and a cross-sectional view (c) thereof;
FIG. 8 is an exploded perspective view for explaining an operational relationship of the plurality of heat sink fins depending on types and mounting positions of heat generating elements among the components of FIG. 1;
FIG. 9 includes a rear view (a) and a side view (b) of FIG. 8; and
FIGS. 10A and 10B are partially cut-away perspective views for explaining a coupling relationship of a heat pipe for dispersing heat in a left-right horizontal direction inside a heat dissipation housing among the components of FIG. 1.

### <Description of reference numerals>

| | | | |
|---|---|---|---|
| 1: | Antenna device | 10: | Heat dissipation housing |
| 20: | Main board | 21: | Upper heat generating element |
| 22C: | High heat generating element | 22: | Intermediate heat generating element |
| 25: | Clamshell | 30: | PSU board |
| 40: | RF module | 41: | MBF element |
| 42: | Antenna element | 50: | Radome panel |
| 60: | Finger guard assembly | 60h-1, 60h-2: | Ventilation holes |
| 70: | External mounting member | 100: | Multiple heat sink fins |
| 110: | Upper heat sink fin | 120: | Intermediate heat sink fin |

| | |
|---|---|
| 130: | Lower heat sink fin |

### [Mode for Invention]

Hereinafter, a heat dissipation apparatus for an electronic device according to an embodiment of the present disclosure will be described in detail with reference to the accompanying drawings.

It is to be noted that in assigning reference numerals to elements in the drawings, the same reference numerals denote the same elements as much as possible even in cases where the elements are shown in different drawings. Furthermore, in describing the embodiments of the present disclosure, a detailed description of the known configurations or functions will be omitted if it is deemed to obscure the understanding for the embodiments of the present disclosure.

In describing the elements of an embodiment of the present disclosure, terms, such as the first, the second, A, B, (a), and (b) may be used. However, the terms are used only to distinguish one element from the other element, and the essence, order, or sequence of the elements is not limited by the terms. Furthermore, unless otherwise defined, all terms used herein including technical or scientific terms have the same meanings as generally understood by those skilled in the art to which the present disclosure pertains. The terms, such as terms defined in dictionaries, which are generally used, should be construed as having meanings identical to contextual meanings of the related art, and are not construed as having ideal or excessively formal meanings unless they are definitely defined in the present disclosure.

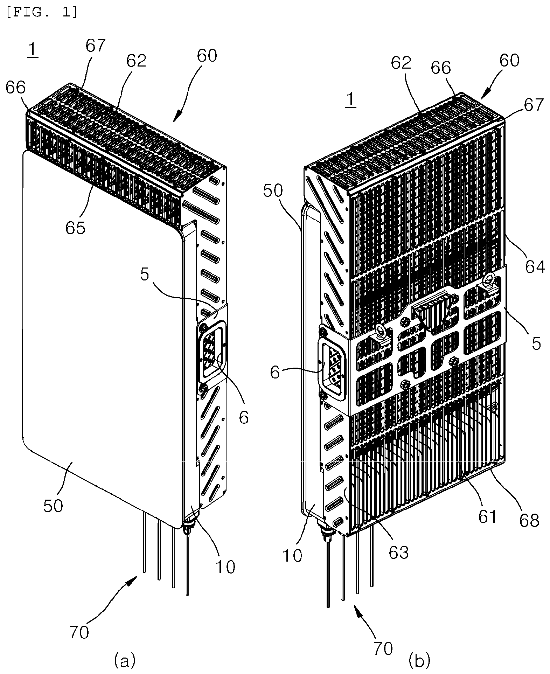

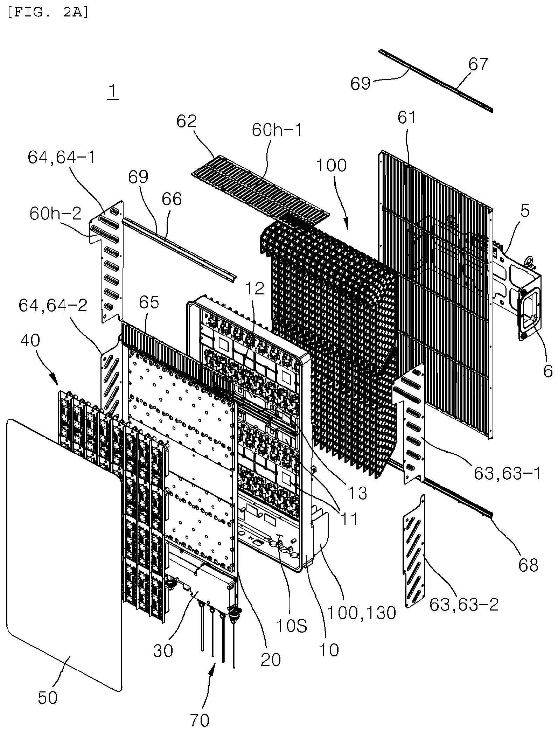

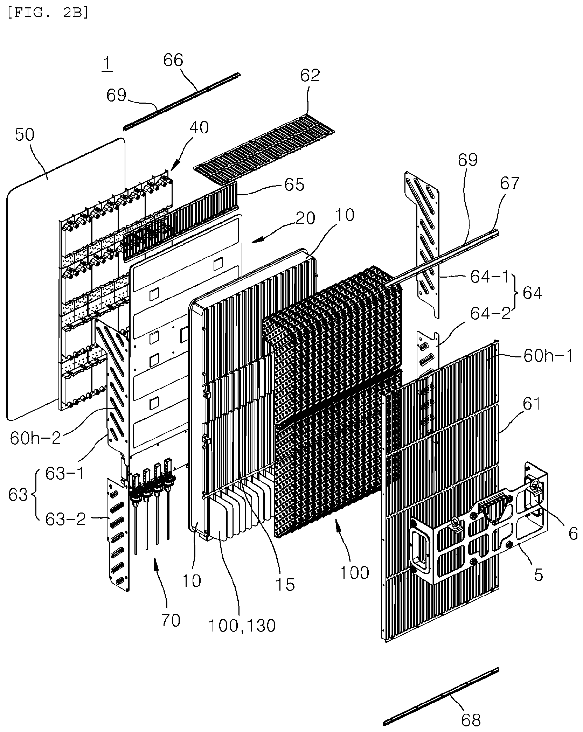

FIG. 1 is front-portion and rear-portion perspective views illustrating a heat dissipation apparatus for an electronic device according to an embodiment of the present disclosure, and FIGS. 2A and 2B are an exploded perspective view of the front portion and an exploded perspective view of the rear portion of FIG. 1.

In general, although a heat-generating device (electronic device) is manufactured in various forms throughout industry, the applicant of the present disclosure is a company engaged in manufacturing other wireless communication equipment, and thus, in describing a heat dissipation apparatus for an electronic device according to an embodiment of the present disclosure below, an antenna device 1, which is a representative heat-generating device (electronic device) that is a heat dissipation target of the heat dissipation apparatus, will be described as a specific example.

However, the electronic device to which the heat dissipation apparatus according to an embodiment of the present disclosure described below is applied should not be construed as being limited only to the antenna device 1. It should be noted that the terms "antenna device 1" and "related components" used below are to be interpreted as including similar electronic devices and components thereof.

First, the antenna device 1, which is adopted as a representative example of the electronic device, will be described as follows.

As illustrated in FIGS. 1 to 2B, the antenna device 1 to which a heat dissipation apparatus according to an embodiment of the present disclosure is applied includes a heat dissipation housing 10 that defines an inner space 10S opened at a front thereof and has a substantially rectangular parallelepiped shape with a long and thin front-to-rear accommodation width extending generally in an up-and-down direction.

Here, the heat dissipation housing 10 provides an installation space (the inner space 10S) for various internal components that will be described below, and is made of a rigid material so as to protect the internal components from external impacts. In particular, the heat dissipation housing is preferably made of a metallic material having excellent thermal conductivity, such that heat generated during system operation by the internal components may be dissipated to the outside by utilizing the thermal conductivity characteristics of the material itself.

Inside the inner space 10S of the heat dissipation housing 10, an RF module 40 formed by a combination of a plurality of MBF (Micro Bellows Filter) elements 41 and antenna elements 42 may be disposed on a front side via a clamshell 25 as a board for a DTU (Digital Transceiving Unit), and a main board 20 on which a kind of heat generating elements are mounted on a rear side, may be stacked and disposed.

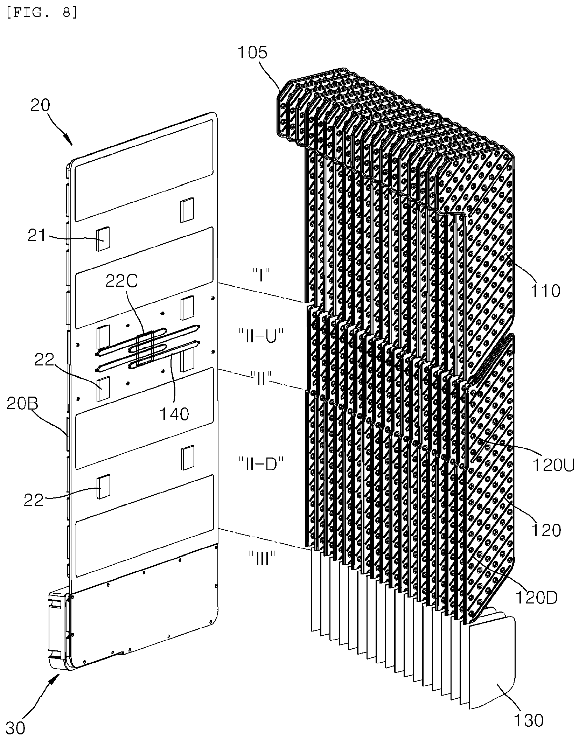

Here, the main board 20 may have mounted thereon components defined as heat generating elements that generate a large amount of heat during operation, such as RFIC elements, PA elements, and FPGA elements, which correspond to reference numerals 21, 22, and 22C in FIG. 8 to be described later.

However, it is to be noted that, in the embodiment of the present disclosure, the electronic device is described by adopting the antenna device 1 merely as an example, and thus the heat generating elements 21, 22, and 22C are not limited to the above-described configuration. For example, the heat generating elements 21, 22, and 22C may be implemented as semiconductor devices, which are representative heat generating elements.

In addition, in a lower portion of the inner space 10S of the heat dissipation housing 10, a PSU board 30 on which electrical components related to a PAU (Power Amplifier Unit) are mounted may be stacked and disposed to have the same layer as the main board 20.

However, the PSU board 30 is not necessarily required to be disposed on the same layer as the main board 20 within the inner space 10S of the heat dissipation housing 10, and the PSU board may be disposed on a different layer in consideration of external shapes of mounted components or rearward protrusion lengths of components mounted on a back surface of the main board 20 and a back surface of the PSU board 30.

For reference, as described later with reference to FIG. 8, the above-described main board 20 is stacked and disposed in an upper region I and an intermediate region II of the inner space 10S of the heat dissipation housing 10, and may generate a relatively larger amount of heat than heat generating elements, which are electrical components of the PSU board 30 disposed in a lower region III corresponding to a lower portion thereof.

Meanwhile, a radome panel 50 is installed on a front side of the inner space 10S of the heat dissipation housing 10, thereby protecting radiation elements implemented by the antenna elements 42 from the outside and simultaneously enabling smooth radiation from the radiation elements.

Here, the radome panel 50 is formed of a material through which radiation beams of the radiation elements may be easily transmitted, and thus may be classified as a component that obstructs heat dissipation of system operation heat generated in the inner space 10S of the heat dissipation housing 10 toward the front side. Thus, the heat dissipation housing 10 itself may be designed to be elongated in a vertical direction so as to increase a heat dissipation surface area for concentrated heat dissipation toward the rear side of the heat dissipation housing 10.

The heat dissipation apparatus according to an embodiment of the present disclosure may be installed on a back surface of the heat dissipation housing 10. Here, the heat dissipation apparatus according to an embodiment of the present disclosure may include a plurality of heat sink fins 100 protruding rearward from the back surface of the heat dissipation housing 10 by a predetermined distance. A detailed description of the plurality of heat sink fins 100 will be provided later.

Meanwhile, as illustrated in FIGS. 2A and 2B, the heat dissipation apparatus for the electronic device according to an embodiment of the present disclosure may further include a finger guard assembly 60 that is provided to surround a rear side and a portion of an upper side of the heat dissipation housing 10, thereby blocking access of an external object (or person) to the plurality of heat sink fins 100.

The finger guard assembly 60 may include a rear finger guard panel 61 vertically disposed in an up-and-down direction to cover entire rear ends of the plurality of heat sink fins 100, an upper top finger guard panel 62 having a rear end coupled to an upper end of the rear finger guard panel 61 and a front end extending forward in a horizontal direction, a right finger guard panel 63 having a front end coupled to a right rear end portion of the heat dissipation housing 10 and a rear end coupled to a right end of the rear finger guard panel 61 and disposed to cover a rear right portion of the heat dissipation housing 10, a left finger guard panel 64 having a front end coupled to a left rear end portion of the heat dissipation housing 10 and a rear end coupled to a left end of the rear finger guard panel 61 and disposed to cover a rear left portion of the heat dissipation housing 10, and an upper front finger guard panel 65 disposed to cover a region between the front end of the upper top finger guard panel 62 and an upper front end of the heat dissipation housing 10.

Here, the right finger guard panel 63 and the left finger guard panel 64 may include upper side guard panels 63-1 and 64-1 installed above a clamping bracket 5 to be described later, and lower side guard panels 63-2 and 64-2 installed below the clamping bracket 5.

Therefore, the upper side guard panels 63-1 and 64-1 may be divided into a right upper side guard panel 63-1 corresponding to the right finger guard panel 63 installed above the clamping bracket 5, and a left upper side guard panel 64-1 corresponding to the left finger guard panel 64 installed above the clamping bracket 5. Further, the lower side guard panels 63-2 and 64-2 may be divided into a right lower side guard panel 63-2 corresponding to the right finger guard panel 63 installed below the clamping bracket 5, and a left lower side guard panel 64-2 corresponding to the left finger guard panel 64 installed below the clamping bracket 5.

Meanwhile, the finger guard assembly 60 may further include guard mounting bars 66, 67, and 68 that provide predetermined screw fastening holes 69 for screw coupling at respective edge portions and simultaneously reinforce rigidity of the edge portions.

Here, the rear finger guard panel to the front finger guard panel 61 to 65 described above may be made of a plastic material to reduce the overall weight of the antenna device 1, and the guard mounting bars 66, 67, and 68 described above may be manufactured in the form of aluminum extrusion bars to reinforce rigidity.

The guard mounting bars 66, 67, and 68 may further include a front guard mounting bar 66 disposed between the upper top finger guard panel 62 and the upper front finger guard panel 65 to provide a plurality of screw fastening holes 69, a rear guard mounting bar 67 disposed between the upper top finger guard panel 62 and the rear finger guard panel 61 to provide a plurality of screw fastening holes 69, and a lower guard mounting bar 68 disposed on a lower end of the rear finger guard panel 61 and having a plurality of screw fastening holes 69 formed therein.

In addition, since the finger guard assembly 60 needs to allow air from an external space (outside air) to be introduced for heat exchange with the plurality of heat sink fins 100 provided therein, a plurality of ventilation holes 60h-1 and 60h-2 having a mesh or grid shape may be formed.

As illustrated in FIGS. 1 to 2B, the finger guard assembly 60 configured as described above may be disposed to surround all of the plurality of heat sink fins 100 coupled to the rear portion of the heat dissipation housing 10, except for lower end portions thereof.

Meanwhile, the clamping bracket 5 for mounting to a pole (not shown) may be installed at left and right end portions of the heat dissipation housing 10 to surround the outer surface of the rear finger guard panel 61 among the components of the finger guard assembly 60 described above.

As described above, the clamping bracket 5 may not only mediate mounting to the pole, but may also function as a handle that allows an on-site worker to grasp and move the antenna device 1 by hand, and handle holes 6 in the form of openings may be formed at left and right end portions thereof to facilitate gripping.

Meanwhile, on an inner surface of the inner space 10S of the heat dissipation housing 10, thermal contact portions 11, 12, and 13 may be formed to match shapes of the heat generating elements 21, 22, and 22C mounted on the back surface of the main board 20 or a back surface shape of the PSU board 30.

Here, the thermal contact portions 11, 12, and 13 may include heat-generating-element contact portions 11 and 12 provided in protruding or recessed forms to be in surface thermal contact with heat-generating surfaces of the heat generating elements 21, 22, and 22C mounted on the back surface of the main board 20, and a heat-pipe contact portion 13 provided in a groove form so that a plurality of heat pipes 140 to be described later (see FIG. 8) may be inserted and installed.

Meanwhile, an external mounting member 70 for electrical or signal connection with the main board 20 disposed in the inner space 10S may be further provided on the lower end portion of the heat dissipation housing 10. The external mounting member 70 may be understood as a component that functions as a connection terminal for all types of connection lines, such as a power cable or a wire, for connecting and supplying electrical power or signals in a general electronic device.

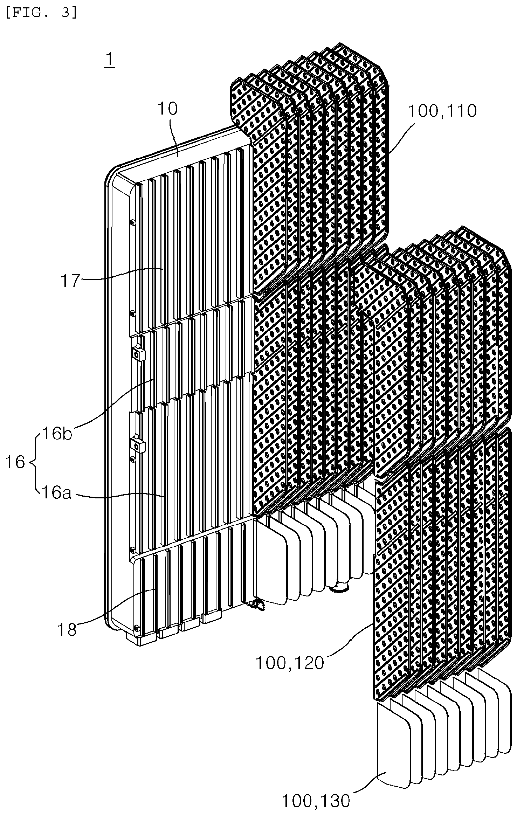

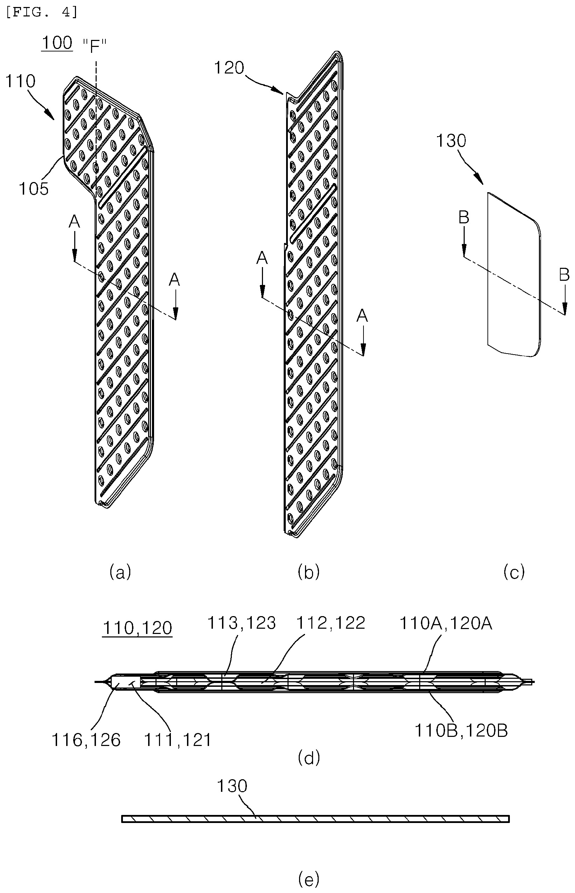

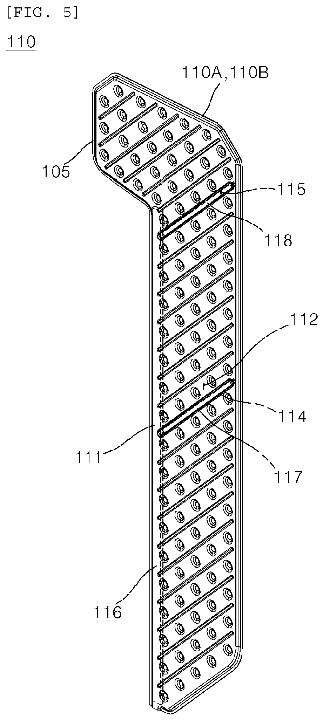

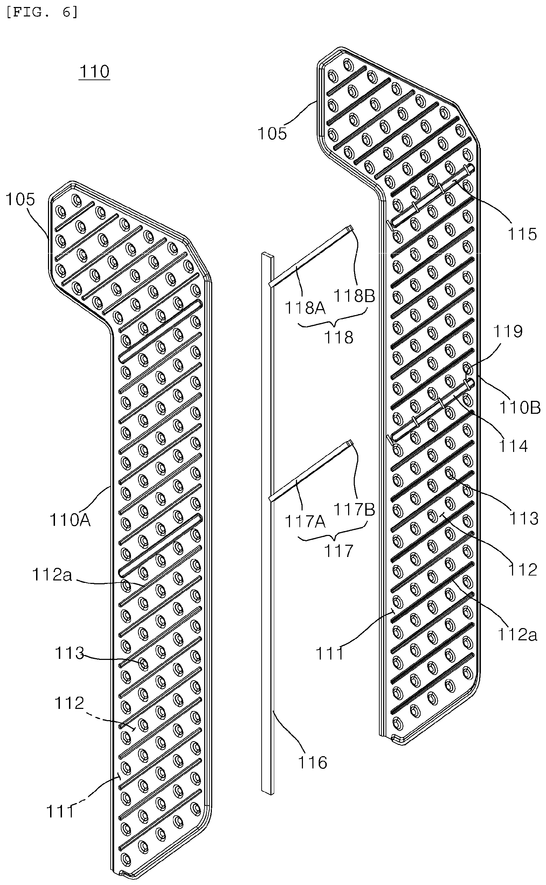

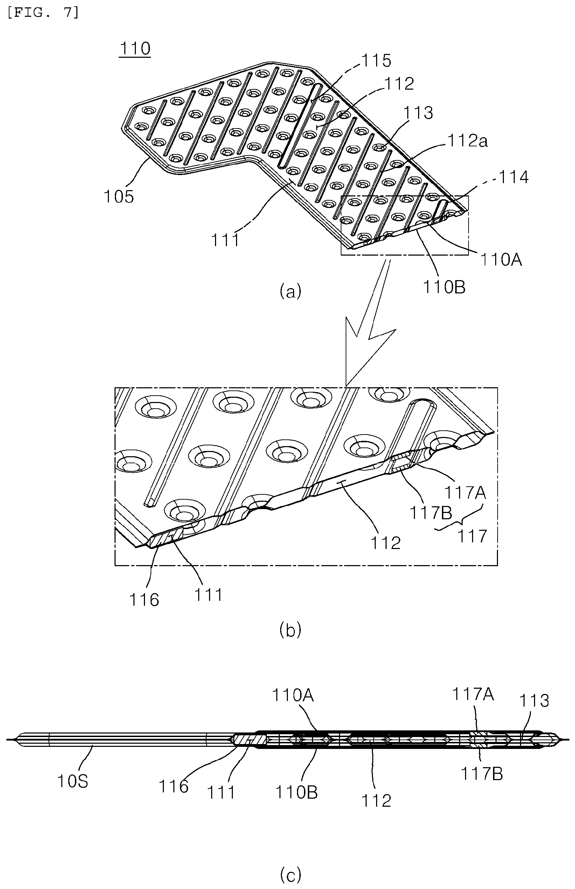

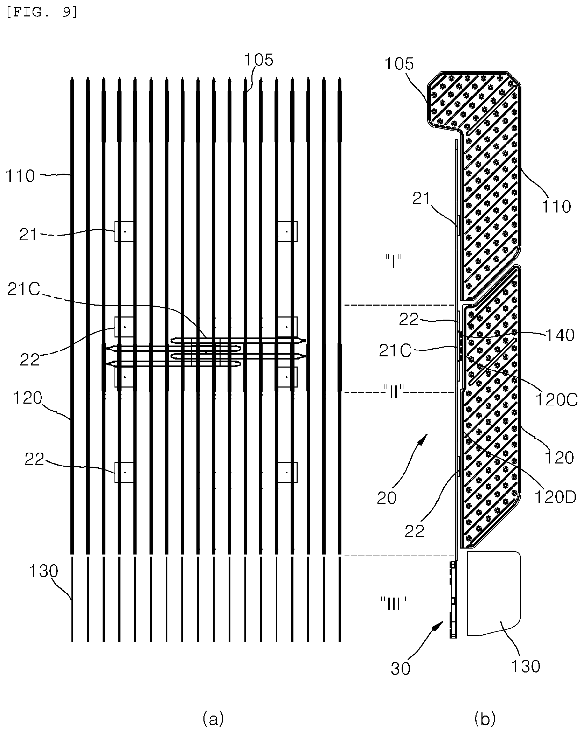

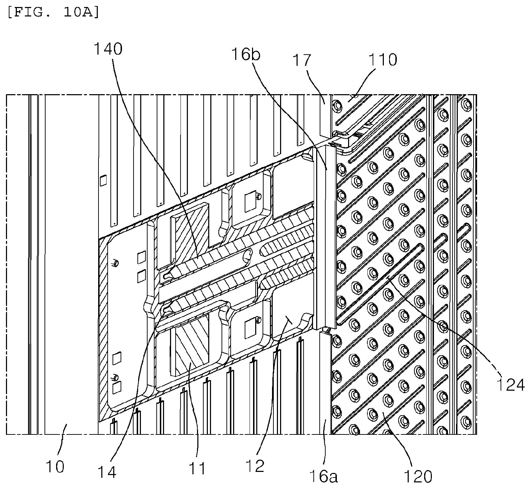

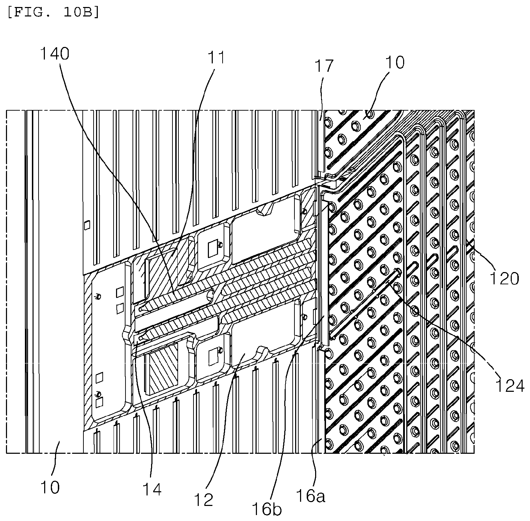

FIG. 3 is a partially exploded rear-portion perspective view for explaining a coupling relationship of a plurality of heat sink fins among components of FIG. 1, FIG. 4 includes perspective views (a, b, c) illustrating the plurality of heat sink fins among the components of FIG. 1, and cross-sectional views (d, e) taken along lines A-A and B-B, respectively, FIG. 5 is a projected perspective view illustrating an upper heat sink fin among the plurality of heat sink fins of FIG. 1, FIG. 6 is an exploded perspective view of FIG. 5, FIG. 7 includes a partially cut-away perspective view (a) of FIG. 5, an enlarged view (b) of the cut-away portion, and a cross-sectional view (c) thereof, FIG. 8 is an exploded perspective view for explaining an operational relationship of the plurality of heat sink fins depending on types and mounting positions of heat generating elements among the components of FIG. 1, FIG. 9 includes a rear view (a) and a side view (b) of FIG. 8, and FIGS. 10A and 10B are partially cut-away perspective views for explaining a coupling relationship of a heat pipe for dispersing heat in a left-right horizontal direction inside a heat dissipation housing among the components of FIG. 1.

A heat dissipation apparatus for an electronic device according to an embodiment of the present disclosure may include a plurality of heat sink fins 100 installed in press-fitting portions 16, 17, and 18 formed on the rear portion of the heat dissipation housing 10, as illustrated in FIG. 3.

Here, the press-fitting portions 16, 17, and 18 may include an upper press-fitting portion 17 to which an upper heat sink fin 110 among the plurality of heat sink fins 100 is coupled, an intermediate press-fitting portion 16 to which an intermediate heat sink fin 120 among the plurality of heat sink fins 100 is coupled, and a lower press-fitting portion 18 to which a lower heat sink fin 130 among the plurality of heat sink fins 100 is coupled.

Such press-fitting portions 16, 17, and 18 are integrally formed on the rear portion of the heat dissipation housing 10, and may be provided in the form of vertically elongated slit grooves such that a front end portion of each of the plurality of heat sink fins 100 is inserted in an interference-fit manner.

However, the press-fitting portions 16, 17, and 18 may be formed such that the elongated slot grooves are recessed forward with respect to the back surface of the heat dissipation housing 10, or alternatively, may be formed such that a pair of slot ribs (reference numeral not shown) protrude rearward with respect to the back surface of the heat dissipation housing 10 to define the elongated slot grooves.

Here, among the press-fitting portions 16, 17, and 18, the intermediate press-fitting portion 16 may be divided into a lower intermediate press-fitting portion 16a into which a lower end portion of an intermediate heat sink fin 120 among the plurality of heat sink fins 100 to be described later is inserted and installed, and an upper intermediate press-fitting portion 16b into which an upper end portion of the intermediate heat sink fin 120 is inserted and installed.

An inner surface of the inner space 10S of the heat dissipation housing 10 in which the upper intermediate press-fitting portion 16b is formed may be formed to protrude further rearward to some extent so as to form the heat-pipe contact portion 13 in which the plurality of heat pipes 140 to be described later are installed.

Here, a depth of slot grooves forming the upper intermediate press-fitting portion 16b and the lower intermediate press-fitting portion 16a, or a protrusion length of the pair of slot ribs, may be formed to be identical. Further, portions of the back surface of the heat dissipation housing 10, on which the upper intermediate press-fitting portion 16b and the lower intermediate press-fitting portion 16a are formed, which serve as a reference for such formation, may be distinguished from each other by stepped surfaces. This will be described in more detail later.

Meanwhile, in the heat dissipation apparatus for the electronic device according to an embodiment of the present disclosure, as illustrated in FIGS. 1 to 3, the plurality of heat sink fins 100 may include an upper heat sink fin 110 and an intermediate heat sink fin 120 that actively dissipate heat generated from the heat generating elements 21, 22, and 22C to the outside using a phase-change material, and a lower heat sink fin 130 that dissipates heat generated from the heat generating elements 21, 22, and 22C to the outside by a heat conduction method based on thermal conductivity of an inherent material, rather than using a phase-change material.

Here, the plurality of heat sink fins 100 may be disposed to extend long in the vertical direction on the rear portion of the heat dissipation housing 10, and may be detachably coupled to be spaced apart from each other by a predetermined distance in the left-right horizontal direction. In order to individually press-fit and install the plurality of heat sink fins 100, the plurality of press-fitting portions 16, 17, and 18 formed on the rear portion of the heat dissipation housing 10 may also be correspondingly arranged to extend long in the vertical direction while being spaced apart from each other by a predetermined distance in the horizontal direction.

At this time, the plurality of heat sink fins 100 may be separately disposed so as to be vertically discontinuous near boundaries between a plurality of regions I, II, and III.

The fact that the plurality of heat sink fins 100 are separately disposed so as to be discontinuous in the vertical direction means that a phase-change flow range of a refrigerant filled in closed-type refrigerant flow spaces 111 and 112 provided inside each of the plurality of heat sink fins 100 to be described later is divided into a plurality of regions in the vertical direction on the rear portion of the heat dissipation housing 10, or means that heat transfer regions are physically separated from each other.

More specifically, as illustrated in FIGS. 8 and 9, the plurality of regions I, II, and III described above may be divided into an upper region I relatively positioned on an upper side of the rear portion of the heat dissipation housing 10, an intermediate region II positioned on a middle portion, and a lower region III positioned on a lower side.

In this case, the plurality of heat sink fins 100 may include an upper heat sink fin 110 coupled to the rear portion of the heat dissipation housing 10 corresponding to the upper region I to dissipate heat from an upper heat generating element 21 positioned in the upper region I among the plurality of types of heat generating elements 21, 22, and 22C, an intermediate heat sink fin 120 coupled to the rear portion of the heat dissipation housing 10 corresponding to the intermediate region II to dissipate heat from intermediate heat generating elements 22 and 22C positioned in the intermediate region II among the plurality of types of heat generating elements 21, 22, and 22C, and a lower heat sink fin 130 coupled to the rear portion of the heat dissipation housing 10 corresponding to the lower region III to dissipate heat from a lower heat generating element (not shown), for example, PSU electrical components, positioned in the lower region III among the plurality of types of heat generating elements 21, 22, and 22C.

As such, the plurality of heat sink fins 100 installed in different types over three regions in the vertical direction may be arranged such that the upper heat sink fin 110, the intermediate heat sink fin 120, and the lower heat sink fin 130 are aligned on a straight vertical line, thereby allowing heat generated by vertical heat dissipation to be easily discharged upward without interference when an upward airflow is formed.

The plurality of heat sink fins 100 configured as described above may each be press-fitted and coupled to the press-fitting portions 16, 17, and 18, which are previously formed on the rear portion of the heat dissipation housing 10, by the interference-fit method.

At this time, although not illustrated in the drawings, it is preferable that the press-fitting portions 16, 17, and 18 are subjected to a thermal epoxy treatment to improve heat transfer efficiency and then the plurality of heat sink fins 100 are press-fitted and inserted, respectively.

Among the plurality of heat sink fins 100, the upper heat sink fin 110 and the intermediate heat sink fin 120 may have a first thermal conductivity, and the lower heat sink fin 130 may be provided to have a second thermal conductivity that is relatively lower than the first thermal conductivity.

As will be described later, the upper heat sink fin 110 and the intermediate heat sink fin 120 include a heat-conductive panel body formed of a SUS material (stainless steel) sheet, and the SUS material is known to have lower thermal conductivity than metals such as aluminum (Al). However, the upper heat sink fin 110 and the intermediate heat sink fin 120 may smoothly release heat through phase change of a refrigerant within refrigerant flow spaces 111 and 112 filled with the refrigerant therein, and thus, the upper heat sink fin 110 and the intermediate heat sink fin 120 may have higher thermal conductivity than the lower heat sink fin 130.

Therefore, the upper heat sink fin 110 and the intermediate heat sink fin 120 are disposed in the upper region I and the intermediate region II, respectively, and are adopted as being suitable for heat dissipation of relatively high heat generating elements 21, 22, and 22C, whereas the lower heat sink fin 130 is disposed in the lower region III and is adopted as being suitable for heat dissipation of relatively low heat generating elements, for example, electrical components of the PSU board.

However, the positional definitions of the upper region to the lower region I to III are merely used to facilitate understanding of the heat dissipation apparatus for the electronic device according to an embodiment of the present disclosure, and the present disclosure is not limited such that the high heat generating elements 21, 22, and 22C should be disposed in the upper region I and the intermediate region II and the low heat generating elements should be disposed in the lower region III. That is, the arrangement positions thereof may be mixed as appropriate.

Here, the upper heat sink fin 110 may further integrally include an extended heat dissipation plate portion 105, in which an upper end portion thereof extends further forward than the press-fitting portion for the rear portion of the heat dissipation housing 10, for example, the upper press-fitting portion 17, so as to cover at least a rear upper portion of the heat dissipation housing 10.

The fact that the extended heat dissipation plate portion 105 is integrally formed with the upper heat sink fin 110 means that a phase-change flow range of the refrigerant filled in the internal refrigerant flow spaces 111 and 112 is increased to a wider region.

That is, the extended heat dissipation plate portion 105 may be formed such that the refrigerant flow spaces 111 and 112, in which the refrigerant is filled inside the upper heat sink fin 110, are extended.

Thus, this corresponds to an increase in a heat dissipation area through which heat is dissipated by heat exchange with outside air via a single upper heat sink fin 110.

Therefore, the extended heat dissipation plate portion 105 formed on an upper side of the upper heat sink fin 110 serves to guide and conduct heat transferred from the upper heat generating element 21 in the upper region I toward an outside-air space above the heat dissipation housing 10, thereby enabling heat dissipation with higher heat dissipation performance.

Meanwhile, in the intermediate region II, in addition to the intermediate heat generating element 22, a high heat generating element 22C having a greater amount of heat generation than the intermediate heat generating element 22 may be further disposed. In an embodiment of the present disclosure, assuming that the electronic device is adopted as the antenna device 1, the upper heat generating element 21 and the intermediate heat generating element 22 may be defined as RFIC elements or PA elements that generate a relatively large amount of heat during electrical operation, whereas the high heat generating element 22C may be defined as an FPGA element.

In this case, the intermediate region II may be divided into an upper intermediate region II-U including a portion in which the high heat generating element 22C is disposed, and a lower intermediate region II-D including a portion in which the high heat generating element 22C is not disposed and only the intermediate heat generating element 22 is disposed.

Here, on an inner surface of the inner space 10S of the heat dissipation housing 10 corresponding to the upper intermediate region II-U, the plurality of heat pipes 140 for dispersing heat generated from the high heat generating element 22C in the left-right horizontal direction of the heat dissipation housing 10 may be installed.

In particular, a front end portion of the intermediate heat sink fin 120 positioned in the upper intermediate region II-U may be formed to be recessed rearward in a stepped manner relative to a front end portion of the intermediate heat sink fin 120 positioned in the lower intermediate region II-D.

This is due to, as described above, a configuration in which respective portions of the back surface of the heat dissipation housing 10 where the upper intermediate press-fitting portion 16b and the lower intermediate press-fitting portion 16a are formed are distinguished by stepped surfaces. That is, this corresponds to a shape design modification for accommodating the upper intermediate press-fitting portion 16b, which protrudes relatively further rearward from the back surface of the heat dissipation housing 10, so as to secure an installation space for the plurality of heat pipes 140 installed in the upper intermediate region II-U.

Meanwhile, among the plurality of heat sink fins 100, the upper heat sink fin 110 and the intermediate heat sink fin 120, as illustrated in FIGS. 4 to 7, include heat-conductive panel bodies 110A and 110B having refrigerant flow spaces 111 and 112, which provide spaces in which the refrigerant is filled and circulates in a gas-liquid phase within a closed space to release heat through phase change.

However, the upper heat sink fin 110 and the intermediate heat sink fin 120 are the same in that both have the refrigerant flow spaces 111 and 112 in which the refrigerant flows inside the heat-conductive panel bodies 110A and 110B, except for a difference that the extended heat dissipation plate portion 105 is formed. Thus, hereinafter, only drawings of the upper heat sink fin 110 will be used for description, and it may be understood that detailed functions and configurations thereof are identical.

Here, although not illustrated in the drawings, the heat-conductive panel bodies 110A and 110B may be formed by processing a single metal panel member into the heat-conductive panel bodies 110A and 110B through a predetermined bending method and joining and sealing edge portions thereof along a peripheral edge, thereby forming the above-described refrigerant flow spaces 111 and 112.

However, the method of forming the refrigerant flow spaces 111 and 112 is not necessarily limited to the above-described single metal panel member type and bending processing method. As illustrated in FIGS. 4 to 7, it is also possible to form the refrigerant flow spaces 111 and 112 by joining entire edge portions of two metal panel members 110A and 110B to each other by a predetermined joining method.

Here, as illustrated in FIGS. 4 to 7, the refrigerant flow spaces 111 and 112 may include a first refrigerant path 111, which corresponds to an evaporation region in which a liquid refrigerant filled therein is evaporated by heat transferred from the heat generating elements 21, 22, and 22C and is formed to extend long in the vertical direction, and a second refrigerant path 112, which serves as the flow path of the liquid refrigerant, is formed in a condensation region other than the evaporation region, and is inclined in a rearward oblique direction such that one end thereof communicates with the first refrigerant path 111 and the other end thereof is positioned higher in a gravity direction than the one end, thereby guiding condensed liquid refrigerant from the condensation region to flow toward the first refrigerant path 111.

The second refrigerant path 112 may have a shape defined by a plurality of inclined guides 112a formed to protrude toward the refrigerant flow spaces 111 and 112, such that substantially condensed liquid refrigerant is prevented from directly falling in a gravity direction and, at the same time, an inclined flow toward the first refrigerant path 111 is guided by surface tension characteristics of the liquid.

In the heat-conductive panel bodies 110A and 110B corresponding to the condensation region, a plurality of strength reinforcement portions 113 may be symmetrically formed to protrude into the refrigerant flow spaces 111 and 112.

When the heat-conductive panel bodies 110A and 110B are joined to each other by a bending method or a joining method, the plurality of strength reinforcement portions 113 may be joined at portions facing each other inside the refrigerant flow spaces 111 and 112 through various coupling methods such as laser welding, thereby serving to reinforce overall strength of the heat-conductive panel bodies 110A and 110B.

Further, the plurality of strength reinforcement portions 113 may also serve to promote active condensation by providing an increased interference area with which vaporized gaseous refrigerant generated for heat dissipation in the condensation region collides.

In addition, the plurality of strength reinforcement portions 113 may be formed to be recessed from outer surfaces of the heat-conductive panel bodies 110A and 110B, which are provided in a planar form, toward the refrigerant flow spaces 111 and 112, thereby increasing a contact area with outside air and additionally serving to facilitate active heat exchange.

Meanwhile, in the evaporation region corresponding to the first refrigerant path 111, an absorber 116 may be further installed to absorb the liquid refrigerant and to promote active vaporization of the absorbed liquid refrigerant by heat supplied from the heat generating elements 21, 22, and 22C.

The absorber 116 may be made of a fibrous material such as a nonwoven fabric having a plurality of pores formed therein. In addition, since the absorber is disposed along the first refrigerant path 111 formed to extend long in the vertical direction, the absorber 116 is preferably made of a material capable of dispersing and transporting the liquid refrigerant by capillary action or inherent absorption force while overcoming gravity in the vertical direction, that is, in a direction opposite to gravity, by at least a predetermined vertical height.

However, as in the upper heat sink fin 110, when the extended heat dissipation plate portion 105 is further provided on an upper side, auxiliary absorbers 117 and 118 may be further provided in at least a portion of the second refrigerant path 112 that forms a boundary with the extended heat dissipation plate portion 105.

The auxiliary absorbers 117 and 118 may be seated and installed in auxiliary absorber installation portions 114 and 115, which are formed by modifying a portion of the second refrigerant path 112 to have a wider width.

The auxiliary absorbers 117 and 118 may include a first auxiliary absorber 117 provided on an intermediate portion of the upper heat sink fin 110 and a second auxiliary absorber 118 provided on a boundary portion of the extended heat dissipation plate portion 105.

In addition, the auxiliary absorber installation portions 114 and 115 may be respectively provided at two locations for individual installation of the first auxiliary absorber 117 and the second auxiliary absorber 118.

In particular, the auxiliary absorbers 117 and 118 may be provided such that first-side auxiliary absorbers 117A and 118A and second-side auxiliary absorbers 117B and 118B are fitted and coupled during mutual joining and forming of the heat-conductive panel bodies 110A and 110B, with a plurality of fixing ribs 119 interposed therebetween, so as to prevent movement thereof.

Meanwhile, although not illustrated in the drawings, spacer protrusions for stably fixing the absorber 116 disposed inside the first refrigerant path 111 formed to extend long in the vertical direction may be further provided. The plurality of fixing ribs 119 described above serve to stably fix the auxiliary absorbers 117 and 118 in the same manner as the spacer protrusions for fixing the absorber 116.

Such fixing ribs 119 may be integrally formed during forming of a pair of heat-conductive panel bodies 110A and 110B.

Here, it is preferable that lower ends of the auxiliary absorbers 117 and 118 are coupled in a form of being connected to the absorber 116. This is to allow condensed refrigerant (liquid refrigerant) absorbed by the auxiliary absorbers 117 and 118 to easily and naturally permeate toward the absorber 116 side, or toward the first refrigerant path 111 side, which is positioned closest to the heat generating elements 21, 22, and 22C.

Meanwhile, the heat-conductive panel bodies 110A and 110B of the upper heat sink fin 110 and the intermediate heat sink fin 120 may be provided in the form of sheets made of a SUS material (stainless steel), and the lower heat sink fin 130 may be provided in the form of a sheet made of an aluminum (Al) material having higher thermal conductivity than the heat-conductive panel bodies 110A and 110B of the upper heat sink fin 110 and the intermediate heat sink fin 120.

The heat dissipation effect of the lower heat sink fin 130 made of an aluminum material, when relying on thermal conductivity of the material itself, is expected to provide much higher heat dissipation performance than cases relying on thermal conductivity of materials of the upper heat sink fin 110 and the intermediate heat sink fin 120. However, since a heat transfer method using a phase-change material, as in the upper heat sink fin 110 and the intermediate heat sink fin 120, provides a remarkably enhanced heat dissipation performance, the lower heat sink fin 130 may be adopted as a heat dissipation configuration suitable for heat generating elements having relatively low heat generation among the heat generating elements provided in the inner space 10S of the heat dissipation housing 10, such as electrical components of a PSU.

However, the lower heat sink fin 130 is not necessarily required to be formed of a metal material different from that of the upper heat sink fin 110 and the intermediate heat sink fin 120, and may also be provided in the form of a sheet made of the same SUS material as the upper heat sink fin 110 and the intermediate heat sink fin 120.

That is, the heat-conductive panel bodies 110A to 110B forming the upper heat sink fin 110 and the intermediate heat sink fin 120 may be provided in the form of SUS material sheets in which the refrigerant flow spaces 111 and 112 are formed therein, and the lower heat sink fin 130 may also be provided in the form of a SUS material sheet, without including the refrigerant flow spaces 111 and 112, such that heat is transferred solely by thermal conductivity of the SUS material itself.

Meanwhile, in the case of the high heat generating element 22C positioned in the upper intermediate region II-U, there may be a problem in that the element is adversely affected by heat due to the high heat transfer performance of the intermediate heat sink fin 120 using a phase-change material.

More specifically, as illustrated in FIGS. 8 and 9, in the case of a high heat generating element 21C such as an FPGA element positioned in the upper intermediate region II-U, there is concern that thermal damage may be caused due to a high temperature at a front end portion of the intermediate heat sink fin 120.

In order to solve such problems, a plurality of heat pipes 140 for dispersing heat generated from the high heat generating element 21C in the left-right horizontal direction of the heat dissipation housing 10 may be installed on the inner surface of the inner space 10S of the heat dissipation housing 10 corresponding to the upper intermediate region II-U.

Each of the heat pipes 140 may also have a closed interior filled with a phase-changeable refrigerant, in which the refrigerant undergoes a phase change into a gaseous state by heat supplied from the high heat generating element 21C, and the gaseous refrigerant diffused through an internal wick structure (not shown) having a plurality of pores exchanges heat via the inner surface of the heat dissipation housing 10, particularly the heat-pipe contact portion 13, thereby undergoing condensation and phase change into the liquid refrigerant.

In particular, the plurality of heat pipes 140 may be provided such that at least one end portion thereof is in surface thermal contact with a heat-generating surface of the high heat generating element 21C, and the other end portion thereof is disposed to extend toward a left end or a right end of the heat dissipation housing 10. Accordingly, high-temperature concentrated heat supplied from the high heat generating element 21C is evenly dispersed and supplied in a left-right horizontal direction to a plurality of intermediate heat sink fins 120 that are spaced apart from each other by a predetermined distance on a rear portion of the heat dissipation housing 10. As described above, the heat dissipation apparatus for an electronic device according to an embodiment of the present disclosure provides an advantage of securing higher heat dissipation performance by allocating specific regions suitable for respective heat generation amounts of the plurality of heat generating elements 21, 22, and 22C, for example, an upper region, an intermediate region, and a lower region, and dissipating heat by vertically separating the regions, rather than dissipating heat using a plurality of heat sink fins arranged uniformly in the vertical direction with respect to heat generated from the plurality of heat generating elements 21, 22, and 22C.

In particular, although the heat dissipation apparatus for the electronic device according to an embodiment of the present disclosure has been described by taking the antenna device 1 and associated components, which are representative electronic devices and are very familiar to the applicant of the present disclosure, as examples, it should be understood that the present disclosure has technical features applicable to any device, regardless of its designation, as long as it relates to heat dissipation of heat generating elements having different amounts of heat generation in a plurality of regions.

The heat dissipation apparatus for the electronic device according to embodiments of the present disclosure has been described in detail with reference to the accompanying drawings. However, embodiments of the present disclosure are not necessarily limited to the above-described embodiments, and it will be apparent that various modifications and equivalent implementations are possible by those skilled in the art. Therefore, the true scope of the present disclosure is defined by the claims set forth below.

### [Industrial Applicability]

The present disclosure provides a heat dissipation apparatus for an electronic device that allows internal heat to be dissipated with uniform heat dissipation performance over an entire vertical region by dividing a plurality of heat sink fins provided on a back surface of a heat dissipation housing into specific heat dissipation regions according to vertical positions of the back surface of the heat dissipation housing and mounting the heat sink fins accordingly.

## Claims

1. A heat dissipation apparatus for an electronic device, the heat dissipation apparatus comprising:
a heat dissipation housing having an inner space that is open at a front;
various types of heat generating elements disposed in a plurality of regions in a vertical direction on an inner surface corresponding to the inner space of the heat dissipation housing; and
a plurality of heat sink fins disposed on a back surface of the heat dissipation housing to extend long in an up-down vertical direction and detachably coupled to be spaced apart from each other by a predetermined distance in a left-right horizontal direction,
wherein the plurality of heat sink fins are separately disposed so as to be discontinuous in the vertical direction near boundaries between a plurality of regions.

2. The heat dissipation apparatus of claim 1, wherein the plurality of heat sink fins are separately disposed so as to interrupt conductive heat transfer in the vertical direction with respect to the back surface of the heat dissipation housing.

3. The heat dissipation apparatus of claim 1, wherein, when the plurality of regions are divided into an upper region relatively positioned on a upper portion of the back surface of the heat dissipation housing, an intermediate region positioned on a middle portion, and a lower region positioned oln a lower portion, the plurality of heat sink fins are installed on the back surface of the heat dissipation housing so as to independently receive heat from the heat generating elements positioned on the respective regions and then to dissipate the heat through independent heat transfer paths.

4. The heat dissipation apparatus of claim 1, wherein, when the plurality of regions are divided into an upper region relatively positioned on an upper portion of the back surface of the heat dissipation housing, an intermediate region positioned on a middle portion, and a lower region positioned on a lower portion, the plurality of heat sink fins comprise:
an upper heat sink fin coupled to the upper region to dissipate heat from an upper heat generating element positioned in the upper region among the plurality of types of heat generating elements;
an intermediate heat sink fin coupled to the intermediate region to dissipate heat from an intermediate heat generating element positioned in the intermediate region among the plurality of types of heat generating elements; and
a lower heat sink fin coupled to the lower region to dissipate heat from a lower heat generating element positioned in the lower region among the plurality of types of heat generating elements.

5. The heat dissipation apparatus of claim 4, wherein the upper heat sink fin, the intermediate heat sink fin, and the lower heat sink fin are arranged on a straight vertical line in the vertical direction.

6. The heat dissipation apparatus of claim 4, wherein:
the upper heat sink fin and the intermediate heat sink fin have a first thermal conductivity,
the lower heat sink fin has a second thermal conductivity that is relatively lower than the first thermal conductivity, and
the upper heat generating element and the intermediate heat generating element positioned in the upper region and the intermediate region dissipate heat at a higher temperature than the lower heat generating element positioned in the lower region.

7. The heat dissipation apparatus of claim 6, wherein a phase-changeable refrigerant is filled inside the upper heat sink fin and the intermediate heat sink fin, and the first thermal conductivity is provided through flow of the refrigerant caused by phase change of the refrigerant.

8. The heat dissipation apparatus of claim 6, wherein the lower heat sink fin has the second thermal conductivity by thermal conductivity of a material itself.

9. The heat dissipation apparatus of claim 6, wherein the upper heat sink fin further comprises an extended heat dissipation plate portion integrally formed thereon, a portion of an upper end thereof extending further forward than the back surface of the heat dissipation housing so as to cover at least a portion of an upper surface of the heat dissipation housing.

10. The heat dissipation apparatus of claim 9, wherein the extended heat dissipation plate portion is formed such that a refrigerant flow space filled with the refrigerant is extended inside the upper heat sink fin.

11. The heat dissipation apparatus of claim 6, wherein, in the intermediate region, a high heat generating element having a greater amount of heat generation than the intermediate heat generating element is further positioned in addition to the intermediate heat generating element, and
the intermediate region is divided into an upper intermediate region including a portion in which the high heat generating element is positioned and a lower intermediate region including a portion in which the high heat generating element is not positioned.

12. The heat dissipation apparatus of claim 11, wherein a plurality of heat pipes for dispersing heat generated from the high heat generating element in the left-right horizontal direction of the heat dissipation housing are installed on an inner surface of the inner space of the heat dissipation housing corresponding to the upper intermediate region.

13. The heat dissipation apparatus of claim 12, wherein the back surface of the heat dissipation housing further comprises press-fitting portions for installation of the plurality of heat sink fins,
when the press-fitting portions comprise an upper press-fitting portion to which the upper heat sink fin among the plurality of heat sink fins is coupled, an intermediate press-fitting portion to which the intermediate heat sink fin among the plurality of heat sink fins is coupled, and a lower press-fitting portion to which the lower heat sink fin among the plurality of heat sink fins is coupled,
a back surface of the heat dissipation housing on which the intermediate press-fitting portion is formed is configured to be distinguished by a stepped surface.

14. The heat dissipation apparatus of claim 12, wherein a front end portion of the intermediate heat sink fin positioned in the upper intermediate region is formed to be recessed rearward in a stepped manner relative to a front end portion of the intermediate heat sink fin positioned in the lower intermediate region.

15. The heat dissipation apparatus of claim 4, wherein the upper heat sink fin and the intermediate heat sink fin each comprise a heat-conductive panel body having a refrigerant flow space, which provides a space in which the refrigerant is filled and circulates in a gas-liquid phase within a closed space to release heat through phase change.

16. The heat dissipation apparatus of claim 15, wherein the refrigerant flow space comprises:
a first refrigerant path serving as an evaporation region and positioned at one end in a width direction to receive heat from the upper heat generating element and the intermediate heat generating elements to be dissipated through the heat-conductive panel body; and
a plurality of second refrigerant paths formed in a condensation region other than the first refrigerant path, the second refrigerant paths serving as flow paths through which a liquid refrigerant, among the refrigerants, condensed from a gaseous state to a liquid state flows from the other end in the width direction of the heat-conductive panel body toward the first refrigerant path by surface tension or gravity.

17. The heat dissipation apparatus of claim 15, wherein the heat-conductive panel body of the upper heat sink fin and the intermediate heat sink fin is provided in the form of a sheet made of a SUS material, and
the lower heat sink fin is provided in the form of a sheet made of an aluminum material having higher thermal conductivity than the heat-conductive panel body.

18. The heat dissipation apparatus of claim 15, wherein:
the heat-conductive panel body of the upper heat sink fin and the intermediate heat sink fin is provided in the form of a sheet made of a SUS material forming the refrigerant flow space, and
the lower heat sink fin is provided in the form of a sheet made of a SUS material that does not include the refrigerant flow space.
